# EUROPEAN PATENT SPECIFICATION

(11) **EP 3 112 018 B1**
(45) Date of publication and mention of the grant of the patent: **14.10.2026**
(21) Application number: 16177654.7
(22) Date of filing: 01.07.2016
(51) Int. Cl.: B01J 19/00, G03F 7/16, C40B 50/18, C40B 60/14

(54) **SYSTEMS AND METHODS TO DISPENSE AND MIX REAGENTS**
SYSTEME UND VERFAHREN ZUM DOSIEREN UND MISCHEN VON REAGENZIEN
SYSTÈMES ET PROCÉDÉS POUR DISTRIBUER ET MÉLANGER DES RÉACTIFS

(30) Priority: 02.07.2015 US 201562188374 P
(43) Date of publication of application: 04.01.2017
(73) Proprietor: Centrillion Technology Holdings Corporation, Grand Cayman, KY1-1104 (KY)
(72) Inventor: CRNOGORAC, Filip, Redwood City, CA 94061 (US); MCGALL, Glenn, Palo Alto, CA 94303 (US); LI, Bolan, Mountain View, CA 94040 (US)
(74) Representative: J A Kemp LLP

(56) References cited:
- EP-A2- 0 947 819
- US-A- 4 889 069
- US-A- 5 695 817
- US-A- 5 843 527
- US-B2- 8 287 954

## Description

### BACKGROUND OF THE INVENTION

The detection of distinctive nucleic acid sequences in a biological sample is critical in many areas, including identifying microorganisms, diagnosing infectious diseases, detecting genetic abnormalities, identifying biomarker associated with various cancers, rating genetic susceptibility to selected diseases, and evaluating patient's response to medical treatments. Over the years, oligonucleotide-based DNA microarrays are becoming increasingly useful for the analysis of gene expression and single nucleotide polymorphisms. DNA microarrays may become a useful tool for large-scale parallel analyses of genome sequence and gene expression. Current applications of DNA microarrays include global analyses of transcriptional processes, evaluation of clinical course of tumors, and accelerated discovery of drug targets.

One way to fabricate DNA microarray is to spot DNA onto nylon membranes or glass slides by robots with pins or ink jet printers. This usually involves naturally available DNA molecules or fragments thereof. When the require DNA sequences are not naturally available, oligonucleotides may be synthesized de novo on the solid surface of the array in a controlled manner. Accordingly, new system and methods to allow controlled chemical synthesis on a solid surface are of interest in the biomedical and biopharmaceutical field.
US 5 695 817 A describes a method of forming a coating film.
EP 0 947 819 A2 describes a sample application method.
US 4 889 069 A describes a coating equipment used for coating a coating solution on a film.
US 5 843 527 A describes a method of applying a coating solution.

### SUMMARY OF THE INVENTION

The invention is defined by the claims. Further aspects and preferred embodiments are defined in the dependent claims. Any aspects, embodiments and examples of the present disclosure which do not fall within the scope of the appended claims do not form part of the invention and are merely provided for illustrative and reference purposes. The present disclosure provides methods, devices and systems for automated high throughput synthesis of chemical entities using low volume chemical reagents on a substrate, for example, in the synthesis of oligonucleotides on a wafer.

The invention provides a wafer processing apparatus for oligonucleotide synthesis comprising:
a wafer conveyance robot configured to move a first wafer for oligonucleotide synthesis from a first position to a second position;
a vacuum chuck at the second position, the vacuum chuck rotatably holding the first wafer;
a lid dispenser at the second position, the lid dispenser comprising a transparent glass lid,
and the lid dispenser being above the vacuum chuck and aligned with the first wafer along a vertical axis;
a nozzle provided by the lid dispenser and above the first wafer, the nozzle dispensing a plurality of reagents onto a surface of the first wafer; and
a reaction chamber, wherein the reaction chamber is the space between a bottom surface of the lid dispenser and a top surface of the first wafer, wherein the reaction chamber has a separation gap ranging from 50 µm to 2 mm between the lid dispenser and the first wafer, and wherein the reaction chamber is configured to be filled with the plurality of reagents to form a thin-film of the plurality of reagents on the first wafer;
wherein the vacuum chuck is configured to rotate the first wafer. The invention also provides a method for processing wafers for oligonucleotide synthesis using the wafer processing apparatus described herein, comprising:
(a) providing the first wafer for oligonucleotide synthesis;
(b) moving the first wafer from the first position to the second position by the wafer conveyance robot;
(c) placing the first wafer on top of the vacuum chuck at the second position, the vacuum chuck rotatably holding the first wafer;
(d) dispensing the plurality of reagents into the reaction chamber, wherein the dispensing is by the nozzle in the lid dispenser when the wafer is stationary; and
(e) spreading the plurality of reagents over the top surface of the first wafer such that the reaction chamber is filled with the plurality of reagents which are mixed to form the thin-film;
wherein the nozzle is placed above the first wafer and projected at the center of the wafer, and wherein the vacuum chuck is configured to rotate the first wafer to mix the plurality of reagents with an additional reagent over the surface of the first wafer. An aspect of the present disclosure provides a wafer processing apparatus comprising: a wafer conveyance robot configured to move a first wafer from a first position to a second position; a vacuum chuck at the second position, the vacuum chuck rotatably holding the first wafer; a lid dispenser at the second position, the lid dispenser aligned with the first wafer along a vertical axis at the center of the first wafer; a nozzle provided by the lid dispenser and above the first wafer, the nozzle dispensing at least one reagent onto a surface of the first wafer when the first wafer is stationary; wherein the vacuum chuck is configured to rotate the first wafer to mix the at least one reagent with an additional reagent over the surface of the first wafer.

In some embodiments of aspects provided herein, when the at least one reagent is dispensed onto the surface of the first wafer, a separation gap (i.e., the thickness of the gap) between the lid dispenser and the first wafer ranges from 50 µm to 2 mm.

In some embodiments of aspects provided herein, the wafer processing apparatus further comprises a first wafer cassette at the first position, the first wafer cassette being configured to hold at least one second wafer. In some embodiments of aspects provided herein, the wafer processing apparatus further comprises a second wafer cassette at a third position, the second wafer cassette being configured to hold at least one third wafer. In some embodiments of aspects provided herein, the wafer conveyance robot is configured to move the first wafer from the second position to the third position.

In some embodiments of aspects provided herein, wherein the at least one second wafer includes the first wafer.

In some embodiments of aspects provided herein, the wafer processing apparatus further comprises an inert atmosphere chamber, the inert atmosphere chamber enclosing the first wafer and the lid dispenser, the inert atmosphere chamber comprising an air inlet and an air outlet, wherein an inert air being introduced into the inert atmosphere chamber through the air inlet and being released out of the inert atmosphere chamber through the air outlet.

In some embodiments of aspects provided herein, wherein at least one relief pattern is implemented on a bottom surface of the lid dispenser or at least one ultrasonic module is implemented within the wafer processing apparatus.

In some embodiments of aspects provided herein, the wafer processing apparatus further comprises a processor for controlling the dispensing of the at least one reagent.

In some embodiments of aspects provided herein, the vacuum chuck rotates the first wafer at a rotational speed of from 1 rpm to 50 rpm, from 51 rpm to 100 rpm, from 101 rpm to 200 rpm, from 201 rpm to 500 rpm, from 501 rpm to 1,000 rpm, from 1,001 to 2,000 rpm, and from 2,001 to 3,000 rpm.

In some embodiments of aspects provided herein, the wafer processing apparatus further comprises a plurality of containers for holding the at least one reagent, wherein the nozzle is in flow communication and operatively associated with each container that selectively and sequentially dispenses an amount of at least one reagent.

In some embodiments of aspects provided herein, the wafer processing apparatus further comprises a drain line under the wafer, the drain line is configured to drain excess at least one reagent.

In some embodiments of aspects provided herein, the wafer processing apparatus further comprises an outlet tube on the lid dispenser, the outlet tube is configured to suck up and drain excess at least one reagent.

In some embodiments of aspects provided herein, the at least one reagent includes a phosphoramidite reagent.

Another aspect of the present disclosure provides method for processing a wafer, comprising: (a) providing a first wafer; (b) moving the first wafer from a first position to a second position by a wafer conveyance robot; (c) placing the first wafer on top of a vacuum chuck at the second position, the vacuum chuck rotatably holding the first wafer; (d) dispensing at least one reagent onto a surface of the first wafer by a nozzle in a lid dispenser at the second position when the first wafer is stationary; wherein the vacuum chuck is configured to rotate the first wafer to mix the at least one reagent with an additional reagent over the surface of the first wafer.

In some embodiments of aspects provided herein,, wherein when the at least one reagent is dispensed onto the surface of the first wafer, a separation gap between the lid dispenser and the first wafer ranges from 50 µm to 2 mm.

In some embodiments of aspects provided herein, wherein moving the first wafer from the first position comprises removing the first wafer from a first wafer cassette at the first position.

In some embodiments of aspects provided herein, the method further comprises enclosing the first wafer and the lid dispenser with an inert atmosphere chamber.

Additional aspects and advantages of the present disclosure will become readily apparent to those skilled in this art from the following detailed description, wherein only illustrative embodiments of the present disclosure are shown and described. As will be realized, the present disclosure is capable of other and different embodiments, and its several details are capable of modifications in various obvious respects, all without departing from the disclosure. Accordingly, the drawings and description are to be regarded as illustrative in nature, and not as restrictive.

### BRIEF DESCRIPTION OF THE DRAWINGS

A better understanding of the features and advantages of the present invention will be obtained by reference to the following detailed description that sets forth illustrative embodiments, in which the principles of the invention are utilized, and the accompanying drawings of which:
FIG. 1 is a perspective view of a wafer processing apparatus 100 as the embodiment of the present disclosure.
FIG. 2 depicts a partial perspective view of the reaction assembly 200 of a wafer processing apparatus as the embodiment of the present disclosure.
FIG. 3 shows a partial sectional view of the reaction assembly 300 of a wafer processing apparatus as the embodiment of the present disclosure.
FIGS. 4 and 5 illustrate partial, perspective views of the reaction assembly 400 of a wafer processing apparatus as the embodiment of the present disclosure.

### DETAILED DESCRIPTION OF THE INVENTION

While various embodiments of the invention have been shown and described herein, it will be obvious to those skilled in the art that such embodiments are provided by way of example only. Numerous variations, changes, and substitutions may occur to those skilled in the art without departing from the invention. It should be understood that various alternatives to the embodiments of the invention described herein may be employed.

Microarrays of de novo synthesized oligonucleotides offer a number of advantages over other types of DNA microarrays, including (i) more controlled specificity of hybridization, which makes them particularly useful for the analysis of single nucleotide polymorphisms or mutational analysis; (ii) versatility to address questions about transcriptome composition such as the presence and prevalence of alternatively spliced or alternatively polyadenylated transcripts; (iii) capacity to systematically screen whole genomic regions for gene discovery; and (iv) ability to generate sequence information independent of biological samples when manufacturing custom-made microarrays.

However, manufacturing custom-made oligonucleotides microarrays may require inert and controlled environment due to the presence of air- and/or moisture-sensitive reagents in oligonucleotide synthesis. Further, chemical synthesis on a solid surface may require the use of large quantity of such air- and/or moisture-sensitive reagents, which may increase the cost of the manufacture or prolong the average turnover time for the manufacture of wafers. Finally, because oligonucleotide synthesis requires the repetition of similar synthetic manipulations with different reagents, contamination by reagent leftovers may present a problem.

After much effort in experimentation, Applicants have found a new system and method for the fabrication of wafers with de novo synthesis of oligonucleotides. In addition, the new system and method may allow automated high throughput manufacturing of wafers involving reduced volume/amount of chemical reagents.

### DEFINITIONS

All terms are intended to be understood as they would be understood by a person skilled in the art. Unless defined otherwise, all technical and scientific terms used herein have the same meaning as commonly understood by one of ordinary skill in the art to which the invention pertains. The following definitions supplement those in the art and are directed to the present disclosure and are not to be imputed to any related or unrelated case, e.g., to any commonly owned patent or application. Although any methods and materials similar or equivalent to those described herein can be used in the practice for testing of the present invention, the preferred materials and methods are described herein. Accordingly, the terminology used herein is for the purpose of describing particular embodiments only, and is not intended to be limiting.

As used in this specification and the appended claims, the singular forms "a," "an" and "the" include plural referents unless the context clearly dictates otherwise. Thus, for example, reference to "a molecule" includes a plurality of such molecules, and the like.

The term "fragment" as used herein generally refers to a fraction of the original DNA sequence or RNA sequence of the particular region.

The term "nucleic acid sequence" or "nucleotide sequence" as used herein refers to nucleic acid molecules with a given sequence of nucleotides, of which it may be desired to know the presence or amount. The nucleotide sequence can comprise ribonucleic acid (RNA) or DNA, or a sequence derived from RNA or DNA. Examples of nucleotide sequences are sequences corresponding to natural or synthetic RNA or DNA including genomic DNA and messenger RNA. The length of the sequence can be any length that can be amplified into nucleic acid amplification products, or amplicons, for example up to about 20, 50, 100, 200, 300, 400, 500, 600, 700, 800, 1,000, 1,200, 1,500, 2,000, 5,000, 10,000 or more than 10,000 nucleotides in length.

The term "about" or "nearly" as used herein generally refers to within +/- 15%, 10%, 9%, 8%, 7%, 6%, 5%, 4%, 3%, 2%, or 1% of the designated amount.

All words of approximation as used herein should be construed to mean "approximate," rather than "perfect," and may accordingly be employed as a meaningful modifier to any other word, specified parameter, quantity, quality, or concept. Words of approximation, include, yet are not limited to terms such as "substantial", "nearly", "almost", "about", "generally", "largely", "essentially", "substantially", "closely approximate", etc. For example, the term "substantially" includes "reasonably close to: nearly, almost, about", connoting a term of approximation known to a person skilled in the art.

A "polynucleotide sequence" or "nucleotide sequence" or "a sequence of a nucleic acid" is a polymer of nucleotides (an oligonucleotide, a DNA, a nucleic acid, etc.) or a character string representing a nucleotide polymer, depending on context. From any specified polynucleotide sequence, either the given nucleic acid or the complementary polynucleotide sequence (e.g., the complementary nucleic acid) can be determined.

The term "array" as used herein, when describing a device, a system, sensors, sample chambers, etc., refers to a one-dimensional or two-dimensional set of microstructures. An array may be any shape. For example, an array may be a series of microstructures arranged in a line, such as the array of squares. An array may be arranged in a square or rectangular grid. There may be sections of the array that are separated from other sections of the array by spaces. An array may have other shapes. For example, an array may be a series of microstructures arranged in a series of concentric circles, in a series of concentric squares, a series of concentric triangles, a series of curves, etc. The spacing between sections of an array or between microstructures in any array may be regular or may be different between particular sections or between particular pairs of microstructures. The microstructure arrays of the present disclosure may be comprised of microstructures having zero-dimensional, one-dimensional or two-dimensional shapes. The microstructures having two-dimensional shapes may have shapes such as squares, rectangles, circles, parallelograms, pentagons, hexagons, irregular shapes, etc.

The terms "plate" and "substrate" as used herein, denote the solid portion of an apparatus whose surface is used to synthesize oligonucleotides or conduct chemical reactions.

A characteristic of a "thin-film," as disclosed herein, is that a layer of mobile phase, solution or liquid is spread over a surface of a plate through the action of surface tension, and/or adhesion to the surface of the plate, and/or centrifugal force. Preferably, a thin film is a liquid sample in which the diffusion time is no more than about four-fold greater, more preferably no more than about three-fold greater, more preferably no more than about two-fold greater, more preferably no more than about one-fold greater in one dimension than that in any other dimension. Preferably, the temperature conductance characteristics of a thin film sample are no more than about four-fold greater, more preferably no more than about three-fold greater, more preferably no more than about two-fold greater, even more preferably no more than about one-fold greater in one dimension than that in any other dimension.

The term "processor," as used herein, refers to a personal computer with associated memory. The processor would have sufficient transient RAM memory, non-transient storage memory, processing power, and hardware, such as interface cards to run the associated control software, interface with and operate the automated components of the apparatus, such as the various pumps, motors, valves, sensors, and detectors, and record the values from the sensors, probes and detectors.

The term "wafer" as used herein, refers to a plate, substrate, or semiconductor chip. The diameter of a wafer can be, for example, about 50 mm, about 100 mm, about 150 mm, about 200 mm, about 250 mm, or other lengths.

### DEVICES AND METHODS

The present disclosure provides methods, devices, and systems to enable fabrication of an array of oligonucleotide on the surface of a plate. The methods, device, and systems of the present disclosure can comprise components including, but not limited to:
1. *Wafer cassette,* which can hold a plurality of wafers. Wafers can be placed into and out of the wafer cassette.
*2. Wafer conveyance robot,* which can retrieve a specific wafer from a first wafer cassette, transfer the wafer to at least one pre-determined location; and replace the wafer to a second wafer cassette. The wafer conveyance robot comprises at least one motor, at least one movable arm, and a wafer holder attached to the end of one arm. The wafer conveyance robot can move horizontally and vertically with the help of the motor(s).
*3. Vacuum chuck,* which can be a vacuum suction type to secure a wafer during the chemical synthesis. It may comprise at least two side arms or at least four side arms to facilitate the positioning of the wafer on top of the vacuum chuck. The vacuum chuck is not limited as long as the chuck can vacuum-suck and hold an object to be sucked and held via a mechanism of a vacuum pump.
*4. Rotary shaft for the vacuum chuck,* which is rotatably operated by a motor. The rotary shaft for the vacuum chuck can rotate the vacuum chuck at a pre-determined rotational speed of, for example, 1-50 rpm, 51- 100 rpm, 101-200 rpm, 201-500 rpm, 501-1,000 rpm, 1,001 rpm to 2,000 rpm, 2,001 rpm to 3,000 rpm, or more than 3,000 rpm . Further, the rotary shaft can be raised or lowered vertically, if desired and equipped with another motor. After reagents has filled the reaction chamber (described below), due to the rotation of the wafer, reagents, including solution and liquid, on the top surface of the wafer may be substantially spread over the top surface of the wafer via the centrifugal force caused by the rotation. Alternatively, the reagents can be mixed by surface tensions. The reagent thus spread may form a thin film over the top surface of the wafer. The rotational speed of the vacuum chuck can be optimized to achieve a desired effect of spreading and mixing reagents.
*5. Lid dispenser,* which can be raised or lowered to a desired height by a motor. The lid dispenser may have at least one supporting column connected to either the motor or an arm controlled by the motor. The lid dispenser is in a disk shape. The bottom face of the lid dispenser is facing the top surface of the wafer on the vacuum chuck and substantially covers the top surface of the wafer when the lid dispenser is lowered. In other words, the lid dispenser may align with the wafer along a vertical axis at the center of and perpendicular to the surface of the wafer. The wafer is circular. In the middle of the disk is a nozzle for controlled delivery of reagents to the top surface of the wafer. The reagents may be solution, liquid or gas. The delivery of reagents may be facilitated by compressed air or a pump. The amount and sequence of reagents to be delivery as well as the rate of delivery is controlled by an external controller, for example, a computer or a microprocessor. The vacuum chuck can rotate the first wafer at a rotational speed of 1-50 rpm, 51-100 rpm, 101-200 rpm, 201-500 rpm, 501-1,000 rpm, 1,001 rpm to 2,000 rpm, 2,001 rpm to 3,000 rpm, and more than 3,000 rpm. The wafer processing apparatus can further comprise a plurality of containers for holding the at least one reagent, wherein the nozzle is in flow communication and operatively associated with each container that selectively and sequentially dispenses an amount of at least one reagent. The reagents can be transferred to the nozzle via a conduit or tube on top of the lid dispenser. When the lid dispenser is lowered, the gap distance between the bottom surface of the lid dispenser and the top surface of the wafer can be controlled. The gap distance ranges from 50 µm to 2 mm. The diameter of the lid dispenser is about the diameter of the wafer it covers, longer than the diameter of the wafer, or shorter than the diameter of the wafer.
*6. Reaction chamber,* which is the space between the lower surface of the lid dispenser and the top surface of the wafer. The reaction chamber is semi-enclosed due to the small gap distance between the two aforementioned surfaces. The range of this gap distance is between 50 µm and 2mm, and is controlled to allow the spreading and mixing of at least one reagent. For example, if the gap distance is too large, reagents dispersed on the surface of the wafer may flow off the surface due to the gravity of the reagents. On the other hand, if the gap distance is too small, there is not enough volume for the surface reactions to occur. The concentrations of the reagents dispersed can be varied according to the volume of the reaction chamber chosen. The reaction chamber can include an aqueous environment in which a plurality of reagents introduced from the nozzle may be present and enabled to react with each other. For example, a newly delivered reagent onto the surface of the wafer may reaction with functional groups attached to the surface of the wafer. A newly delivered reagent may react with previously delivered reagent(s) staying on the surface of the wafer. Optionally, the lid dispenser, the wafer and the vacuum chuck are placed inside a controlled atmosphere chamber or an inert atmosphere chamber filled with inert air, such as nitrogen or argon. In addition, the controlled atmosphere chamber or the inert atmosphere chamber may have an inert air inlet and an inert air outlet so that a constant air flow is maintained within the controlled atmosphere chamber.

In addition, the device may comprise a computer system to control, for example, the delivery of the reagents, the movement of parts of the device, and other operation of the device.

The components of the apparatus can be made from stainless steel, aluminum, non-ferrous alloys, Teflon^{®}, high density poly ethylene (HDPE), or any other material understood by those of ordinary skill in the art for use in particular applications that may depend on the solution acidity or alkalinity, salinity, temperature, or other chemical or physical properties, as well as the ability to prevent contamination and be properly cleaned between chemical reactions.

Methods, devices, and systems of the present disclosure can employ variants of the above components assembled together to create a system capable of manufacture wafers and conducting surface chemistry on the surface of the wafers.

### General Methods

The present disclosure employs, unless otherwise indicated, conventional techniques in photolithography, chemical etching, general machining, microfluidics, organic chemistry, biochemistry, oligonucleotide synthesis and modification, nucleic acid hybridization, molecular biology, microbiology, genetic analysis, recombinant DNA, and related fields as are within the skill of the art. These techniques are described in the references cited herein and are fully explained in the literature. *See,* for example, Maniatis, Fritsch & Sambrook, MOLECULAR CLONING: A LABORATORY MANUAL, Cold Spring Harbor Laboratory Press (1982); Sambrook, Fritsch & Maniatis, MOLECULAR CLONING: A LABORATORY MANUAL, Second Edition, Cold Spring Harbor Laboratory Press (1989); Ausubel, et al., CURRENT PROTOCOLS IN MOLECULAR BIOLOGY, John Wiley & Sons (1987 and annual updates); Gait (ed.), OLIGONUCLEOTIDE SYNTHESIS: A PRACTICAL APPROACH, IRL Press (1984); Eckstein (ed.), OLIGONUCLEOTIDES AND ANALOGUES: A PRACTICAL APPROACH, IRL Press (1991); Birren et al. (eds.) GENOME ANALYSIS: A LABORATORY MANUAL, Cold Spring Harbor Laboratory Press, 1999.

### EXAMPLES

The system and method of a wafer processing apparatus according to the present disclosure will be described below with reference to the drawings.

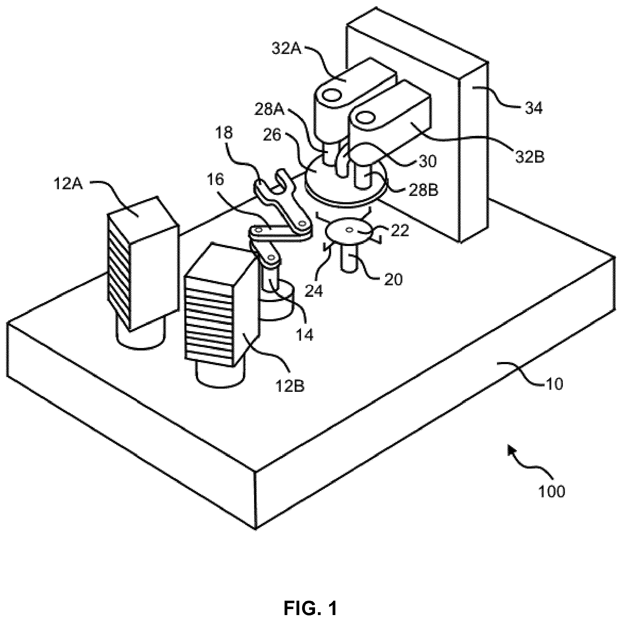

FIG. 1 is a perspective diagram showing the general structures of a wafer processing apparatus 100 according to a first embodiment of the present disclosure. In FIG. 1, a wafer conveyance robot 16 composes a first robot mechanism 14 and a wafer holder 18. The wafer conveyance robot 16 is on a polar coordinate system and disposed on an upper surface of a base 10. Wafer cassettes 12A and 12B, and a vacuum chuck 22 are disposed radially around the wafer conveyance robot 16. The wafer cassettes 12A and 12B, and the vacuum chuck 22 are arranged in a range in which a wafer can be brought in and out from the wafer cassettes 12A and 12B by the wafer conveyance robot 16, and placed on the top of the vacuum chuck 22.

The wafer cassettes 12A and 12B accommodate a plurality of wafers before and after wafer processing. The first robot mechanism 14 can move vertically and horizontally so that a wafer can be brought in and out by the wafer conveyance robot 16, and placed on the top of the vacuum chuck 22. The vacuum chuck 22 may comprise side arms 24 so that when a wafer is placed on top of the vacuum chuck 22 by the wafer holder 18, the wafer is centered on the vacuum chuck 22. A vacuum applied via the vacuum chuck 22 holds the wafer in place and forces the wafer move together with the vacuum chuck 22. Further, the vacuum chuck 22 is positioned on top of a rotary shaft 20 which spins the vacuum chuck 22 together with the wafer vacuum-sucked onto the vacuum chuck 22. The rotary shaft may optionally move vertically to adjust the height of the wafer.

Directly above the vacuum chuck 22 is a lid dispenser 26. The lid dispenser 26 may be in a flat disk shape. The bottom surface of the lid dispenser 26 faces the top surface of the wafer on the vacuum chuck 22 and substantially covers the top surface of the wafer when the lid dispenser 26 is lowered into the position for conducting chemical synthesis. In other words, the lid dispenser 26 may align with the wafer along a vertical axis at the center of and perpendicular to the surface of the wafer. The wafer is circular. There are two supporting columns 28A and 28B holding the lid dispenser 26. The two supporting columns 28A and 28B are connected with a wall portion 34 via side arms 32A and 32B, respectively. The side arms 32A and 32B can move vertically and/or horizontally with the help of robot(s)/motor(s).

The operation of the wafer processing apparatus starts with the removal of one wafer from the wafer cassette 12A by the wafer conveyance robot 16 via the wafer holder 18. Then the wafer conveyance robot 16 places the wafer on top of the vacuum chuck 22. Vacuum is applied to the bottom surface of the wafer which is suction-adhered to the vacuum chuck 22.

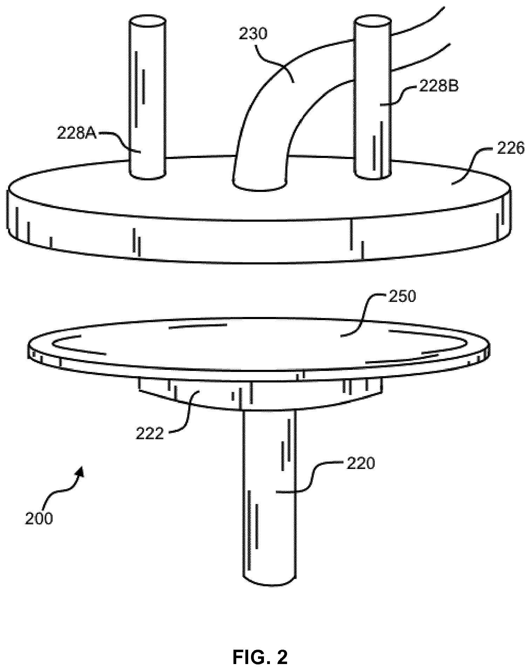

Turning now to FIG. 2, the relative layout of the lid dispenser and the vacuum chuck is shown as reaction assembly 200 according to one embodiment of the present disclosure. The reaction assembly 200 comprises a vacuum chuck 222 positioned on and rotated by a rotary shaft 220. A wafer 250 is placed on top of the vacuum chuck 222 and suction-adhered to the vacuum chuck 222. As a result, when the rotary shaft 220 rotates, so do the vacuum chuck 222 and wafer 250.

The reaction assembly 200 further comprises a lid dispenser 226 on top of the wafer 250. As shown in FIG. 2, the lid dispenser 226 aligns with the wafer 250 along a vertical axis at the center of and perpendicular to the surface of the wafer 250. The wafer 250 and the bottom surface of the lid dispenser 226 are circular. The lid dispenser 226 is movable with the help of two supporting columns 228A and 228B vertically, and optionally, movable on the horizontal plane via another motor. In addition, a conduit or tube 230 is inserted in the center of the lid dispenser 226 and delivers reagents to the top surface of the wafer 250 below the lid dispenser 226 in a controlled manner. The conduit or tube 230 can transfer gas, liquid or solution at a predetermined rate and in a predetermined amount. The conduit or tube 230 may be washed or gas dried in-between different deliveries of reagents so that contamination of reagents within the conduit or tube 230 is minimized. The delivery of reagents may be air-propelled or pump-controlled.

When air is used, it is preferably inert air, for example, nitrogen and argon. Added advantages of using inert air to deliver reagents include drying of the conduit or tube 230 between deliveries using the passage of inert air; protection of air- or moisture-sensitive reagents during delivery; maintaining a positive pressure of inert air over the top surface of the wafer 250 during chemical synthesis; and removing excess reagents from the surface of the wafer 250, either by evaporation or by pushing the reagents over the edge of the wafer 250.

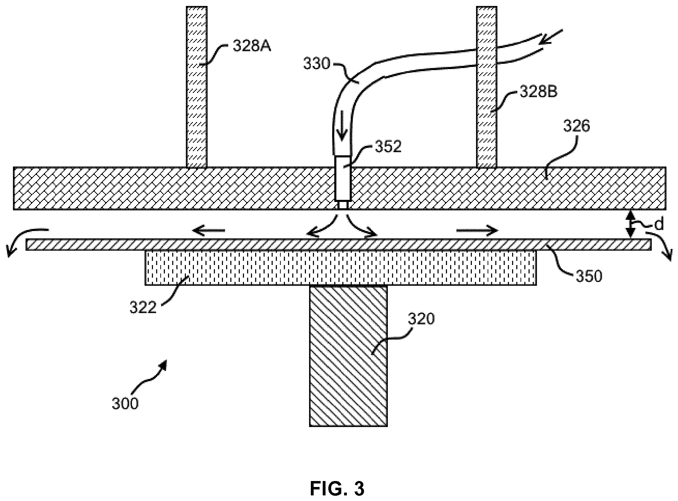

Referring to FIG. 3, the relative layout of the lid dispenser and the vacuum chuck is further depicted as reaction assembly 300 according to another embodiment of the present disclosure. In the center of a lid dispenser 326 is a nozzle 352 for controlled delivery of reagents to the top surface of a wafer 350, which is supported and secured by a vacuum chuck 322. The reagents delivered may be solution, liquid or gas. The delivery of reagents may be facilitated by compressed air or a pump. The amount and sequence of reagents to be delivery as well as the rate of delivery is controlled by an external controller, for example, a computer or a microprocessor. The reagents can be transferred to the nozzle 352 via a conduit or tube 330 on the top of the lid dispenser 326. Because the wafer 350 on top of the vacuum chuck 322 is rotated by the rotary shaft 320, reagents dropped onto the center of the wafer 350 will be spread substantially evenly over the top surface of the wafer 350 due to the centrifugal force generated by the rotation. Further, the spin or rotation of the wafer 350 can mix different reagents delivered onto the top surface of the wafer 350. In addition, the spin or rotation of the wafer 350 can spin off excess reagents from the top surface of the wafer 350 by pushing the excess reagent over the edge of the wafer 350. The lid dispenser 326 is movable with the help of supporting columns 328A and 328B vertically, and optionally movable on the horizontal plane via another motor.

When the lid dispenser 326 is lowered, the gap distance d between the bottom surface of the lid dispenser 326 and the top surface of the wafer 350 can be controlled. The gap distance d between the top surface of the wafer 350 and the bottom surface of the lid dispenser 326 ranges from 50 µm to 2 mm. The diameter of the lid dispenser 326 is about the diameter of the wafer 350 it covers, longer than the diameter of the wafer 350, or shorter than the diameter of the wafer 350. In a preferred embodiment, the diameter of the lid dispenser 326 is longer than the diameter of the wafer 350. The diameter of the wafer 350 can be, for example, about 50 mm, about 100 mm, about 150 mm, about 200 mm, about 250 mm, or other lengths.

Reagents, gas, liquid or solution, are introduced into the conduit or tube 330 in a controlled manner. The nozzle 352 delivers the reagents onto the top surface of the wafer 350 when the wafer 350 is stationary. Liquid reagents may spread by capillary action without spinning the wafer 350. After the reaction chamber has been filled with reagents, the wafer 350 may spin to mix the reagents in the reaction chamber. Due to the centrifugation of the rotating wafer, the delivered reagents may form a substantially flat surface, e.g., forming a thin-film. The series of arrows with thin arrowheads in FIG. 3 show the general direction of the reagents in the conduit or tube 330 and the nozzle 352, and the directions of the reagent's flowing patterns once delivered onto the top surface of the wafer 350.

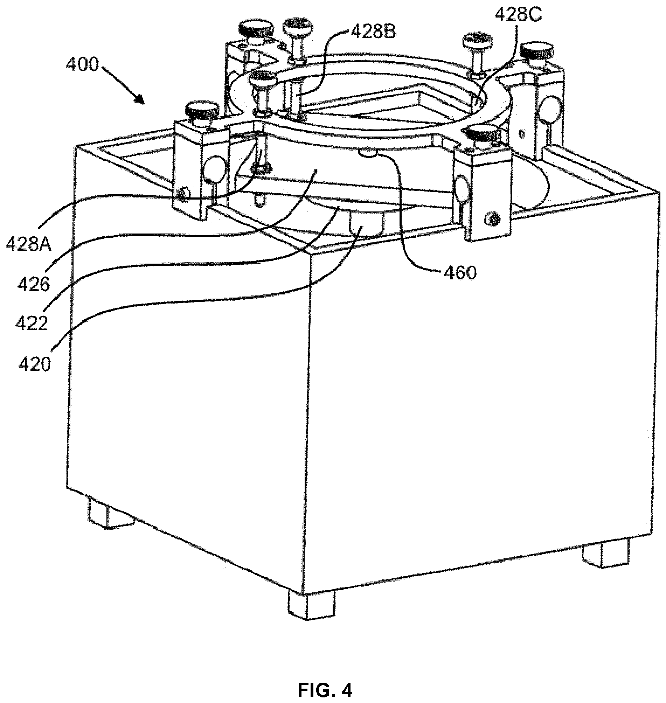

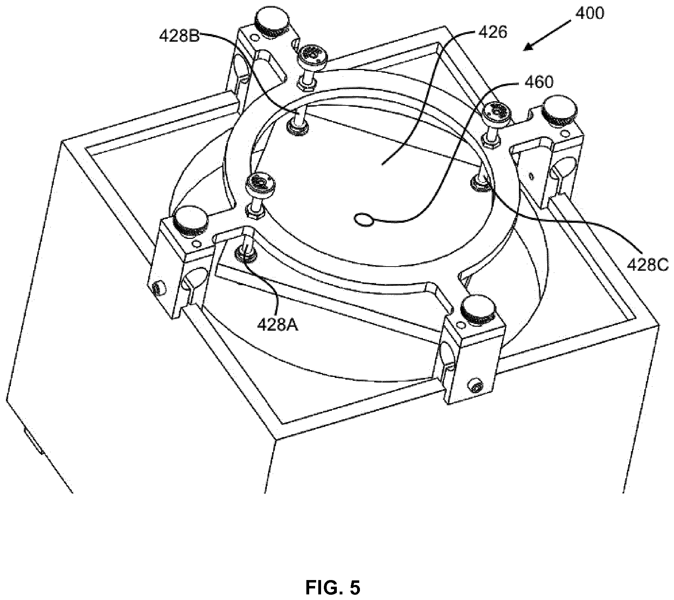

Turning now to FIGS. 4-5, a partial, perspective graphical depiction of a reaction assembly 400 is illustrated according to another embodiment of the present disclosure. A lid dispenser 426 is movable with the help of supporting columns 428A, 428B and 428C vertically. In the center of the lid dispenser 426 is a hole 460, through which a nozzle and/or an inlet tube can be inserted to dispense at least one reagent in a controlled manner. Underneath the lid dispenser 426 is a vacuum chuck 422 configured to support and secure a wafer, onto whose surface the nozzle can deliver the at least one reagent. The vacuum chuck 422 is rotatable by a rotary shaft 420.

After chemical processing of the wafer is completed, the wafer may be dried by either continuous inert air flow or continuous spin. When the wafer is considered dry enough, turning back to FIG. 1, the vacuum applied by the vacuum chuck 22 is relieved. Then the wafer conveyance robot 16 removes the processed wafer from the top of the vacuum chuck 22 to the inside of wafer cassette 12B for storage. Finally, the wafer conveyance robot 16 is ready to remove another wafer from wafer cassette 12A for another round of wafer processing.

As shown and explained above, Applicant presented a design that uses a robotically operated system to achieve automated high-throughput fabrication of wafers with minimal user intervention. Alternatively, the wafer conveyance robot may be replaced with a wafer track for wafer transferring tasks.

Further, an independently controlled chemical delivery system via the lid dispenser is used to deliver different chemical reagents onto the center of the surface of the wafer. Spinning of the wafer makes the delivered reagents moving from the center of the surface of the wafer to the edge of the surface of the wafer, thereby provides stirring/mixing of different reagents to facilitate chemical reactions between reagents on the surface of the wafer. Excessive heat or gaseous byproducts of the surface reactions may be dispersed by a continuous flow of inert air either through the chemical delivery system or a separate gas inlet/outlet system.

In one embodiment, the lid dispenser has about the same diameter as the wafer below the lid dispenser so that the bottom surface of the lid dispenser and the top surface of the wafer form a semi-enclosed reaction chamber in-between the two surfaces. Chemical reactions happen in this semi-enclosed reaction chamber. The volume of the reaction chamber is equal to the surface area of the wafer times the separation gap between the two surfaces: Volume = A_{wafer} × d_{gap}, wherein A_{wafer} is the surface area of the wafer, and d_{gap} is the gap distance between the two surfaces. This Volume can be considered, approximately, the volume of reagents used in the chemical process because the wafer can only accommodate such a volume of each reagent according to the present disclosure. For example, if the diameter of the wafer is about 150 mm and the separation gap is about 0.5 mm, the volume of the semi-enclosed reaction chamber is about 8 mL. This volume of the reaction chamber is a reduction in reagent volume when compared with puddle drop systems used for polymer resist development. In the puddle drop systems, the volume of reagent used is determined by the meniscus caused by surface tension. Moreover, if reagents used are volatile or sensitive to ambient air or moisture, for example, when phosphoramidites are used, the semi-enclosed reaction chamber according to the present disclosure minimizes evaporation and reduces contamination because only the outer edge of the thin film layer of the reagent on top of the wafer is in contact with ambient air. The exposed surface of the reagent is: Area of exposure = π × d_{wafer} × d_{gap}, wherein d_{wafer} is the diameter of the wafer. The Area of exposure is significantly smaller than that when no lid dispenser or cover stays close to the wafer since the top surface of the thin film on the wafer of the present disclosure is not exposed to ambient air.

In another embodiment, after the reagents permeate the reaction chamber and cover the wafer surface by capillary action or other mechanisms, the wafer can be slowly rotated or spun to ensure that reagents added are mixed, thereby improving uniformity of distribution of the reagents across the surface of the wafer. In addition, the movement of liquid against a stationary bottom surface of the lid dispenser can provide some reagent mixing. Alternatively, relief patterns can be implemented on the bottom surface of the lid dispenser, or ultrasonic module(s) can be added to the reaction chamber, so that reagent mixing can be improved.

In one embodiment, there is no outlet port for the delivered chemicals. Excess chemicals can be either spun off the edge of the wafer at higher rotational speeds of the rotary shaft, pushed off the edge by the delivery of the next chemical reagent, pushed through by a puff of a processing inert gas, or any combination of the above methods. Further, process optimization to control the volume of reaction added or vacuum chuck design with a chemical waste collection portion underneath the vacuum chuck can prevent used or discarded chemicals from dripping onto the bottom surface of the wafer. In addition, additional outlet(s) may be added at the base 10 to remove spun-off or discarded chemicals. Similarly, at the completion of the wafer processing, the wafer can be spun dry with a wider, pre-determined separation gap between the two surfaces, dried at an elevated temperature, or blown dried by a process gas from the lid dispenser, or a combination of the above. Alternatively, an outlet tube can be inserted into the lid dispenser away from the nozzle and the tube (i.e. the inlet tube to deliver reagents) connected to the nozzle. The outlet tube is configured to suck up excess reagents, used up reagents, or reagents remained in liquid forms in a controlled manner (for example, after a predetermined time of mixing/spinning) and transport the sucked-up reagents to a waste container. For example, vacuum can be applied to the outlet tube to suck up reagents. Then the next reagent can be delivered via the inlet tube and the nozzle to fill the reaction chamber.

In another embodiment, the lid dispenser can be cleaned with a flow of wash solution/solvent through the separation gap prior to drying of the bottom surface of the lid dispenser. This ensures minimal contamination between process steps or cross-contamination of reagents.

In one embodiment, for oligonucleotide synthesis application of the present disclosure, Applicants use flexible 3/16" OD FEP tubing to deliver reagents to a machined glass lid dispenser, both of which are inert to the solvents used in the oligonucleotide synthesis. Further, a separation gap of about 0.5 mm is implemented when delivering reagents to the top surface of the wafer with an about 150 mm diameter so that about 8 mL of reagent volume is expected to fill the reaction chamber defined by the bottom surface of the lid dispenser and the top surface of the wafer. All chemical reagent manipulation can be controlled by an external oligosynthesizer or an event management system, which communicates with the reaction chamber to perform desired tasks, including but not limited to, setting up gap distance, rotation speed of the rotary shaft, amount and speed of reagent delivery, etc.

In another embodiment, solvents used as part of the at least one reagent include but are not limited to: DI water, acetonitrile (ACN), trichloromethane (TCM), and THF. The wafer can be a glass wafer. The lid dispenser can be a glass lid dispenser. The shape of the dispenser includes but is not limited to: circular and square. The wafer can be spun up to up to 3,000 rpm with the help of the vacuum chuck and the rotary shaft. The rotation speed can be adjusted to spin off excess reagents from the reaction chamber. For example, spinning at about 1,000 rpm can spin off excess reagents from the reaction chamber.

In one embodiment, in order to make the opposing surfaces of the wafer and the lid dispenser parallel before the addition of the at least one reagent, about 50% of the reaction chamber volume can be filled with water. Subsequently the wafer is spun, for example, at about 20 rpm. The water meniscus in the reaction chamber forms an ellipse or a circle, which can be viewed through the glass lid of the lid dispenser on top of the wafer or by other detecting devices. Then the supporting columns for the lid dispenser can be adjusted manually, mechanically, or automatically to make the observed water meniscus a circle or substantially a circle (instead of an ellipse when viewed from the glass lid on top of the wafer) centered at the rotation axis of the wafer. In this way the gap distance between the opposing surfaces of the lid dispenser and the wafer can be substantially equal or even, and thereby the lid dispenser and the wafer are substantially parallel.

### INDUSTRIAL APPLICATION OF THE PRESENT DISCLOSURE

The advantage of the wafer processing apparatus, system and method include:
a) High throughput platform via automated cassette-to-cassette handling
b) No mechanical contact to the top surface of the wafer by robots or other components of the apparatus during wafer processing
c) Low volume of reagent usage which is determined by the separation gap and the delivery rate
d) Minimal reagent loss due to evaporation or contamination because the semi-enclosed nature of the reaction chamber with optional inert air chamber enclosing the reaction chamber
e) Built-in reagent mixing via wafer rotation
f) Ease of wafer drying
g) Self-cleaning, prevention of cross-contamination by different reagents

Even though FIGS. 1-5 depict the wafer processing apparatus and its components as having certain relative dimensions, such dimensions are only exemplary and other relative dimensions are possible.

## Claims

1. A wafer processing apparatus for oligonucleotide synthesis comprising:
a wafer conveyance robot configured to move a first wafer for oligonucleotide synthesis from a first position to a second position;
a vacuum chuck at the second position, the vacuum chuck rotatably holding the first wafer;
a lid dispenser at the second position, the lid dispenser comprising a transparent glass lid, and the lid dispenser being above the vacuum chuck and aligned with the first wafer along a vertical axis;
a nozzle provided by the lid dispenser and above the first wafer, the nozzle dispensing a plurality of reagents onto a surface of the first wafer; and
a reaction chamber, wherein the reaction chamber is the space between a bottom surface of the lid dispenser and a top surface of the first wafer, wherein the reaction chamber has a separation gap ranging from 50 µm to 2 mm between the lid dispenser and the first wafer, and wherein the reaction chamber is configured to be filled with the plurality of reagents to form a thin-film of the plurality of reagents on the first wafer;
wherein the vacuum chuck is configured to rotate the first wafer.

2. The wafer processing apparatus of claim 1 further comprises a first wafer cassette at the first position, the first wafer cassette being configured to hold at least one second wafer for oligonucleotide synthesis.

3. The wafer processing apparatus of claim 2 further comprises a second wafer cassette at a third position, the second wafer cassette being configured to hold at least one third wafer for oligonucleotide synthesis.

4. The wafer processing apparatus of claim 3, wherein the wafer conveyance robot is configured to move the first wafer from the second position to the third position.

5. The wafer processing apparatus of claim 1 further comprises a processor for controlling the dispensing of the plurality of reagents.

6. The wafer processing apparatus of claim 1 further comprises an inert atmosphere chamber, the inert atmosphere chamber enclosing the first wafer and the lid dispenser, the inert atmosphere chamber comprising an air inlet and an air outlet, wherein an inert gas being introduced into the inert atmosphere chamber through the air inlet and being released out of the inert atmosphere chamber through the air outlet.

7. The wafer processing apparatus of claim 1, wherein at least one relief pattern is implemented on a bottom surface of the lid dispenser or at least one ultrasonic module is implemented within the wafer processing apparatus configured to improve the reagent mixing.

8. The wafer processing apparatus of claim 1 further comprises an outlet, wherein the outlet is an outlet tube in the lid dispenser configured to remove excess plurality of reagents from the surface of the wafer.

9. The wafer processing apparatus of claim 1 further comprises a plurality of containers for holding the plurality of reagents, wherein the nozzle is in flow communication and operatively associated with each container that selectively and sequentially dispenses an amount of plurality of reagents.

10. A method for processing wafers for oligonucleotide synthesis using the wafer processing apparatus of claim 1, comprising:
(a) providing the first wafer for oligonucleotide synthesis;
(b) moving the first wafer from the first position to the second position by the wafer conveyance robot;
(c) placing the first wafer on top of the vacuum chuck at the second position, the vacuum chuck rotatably holding the first wafer;
(d) dispensing the plurality of reagents into the reaction chamber, wherein the dispensing is by the nozzle in the lid dispenser when the wafer is stationary; and
(e) spreading the plurality of reagents over the top surface of the first wafer such that the reaction chamber is filled with the plurality of reagents which are mixed to form the thin-film;
wherein the nozzle is placed above the first wafer and projected at the center of the wafer, and wherein the vacuum chuck is configured to rotate the first wafer to mix the plurality of reagents with an additional reagent over the surface of the first wafer.

11. The method of claim 10, wherein in step (d) prior to dispensing the plurality of reagents, dispensing a predetermined amount of water onto the top surface of the first wafer by the nozzle, rotating the first wafer, adjusting support columns of the lid dispenser to make a bottom surface of the lid dispenser and the top surface of the first wafer substantially parallel.

12. The method of claim 10, wherein the moving the first wafer from the first position comprises removing the first wafer from a first wafer cassette at the first position.

13. The method of claim 10, further comprising (f) removing excess plurality of reagents from the surface of the first wafer by rotating the first wafer up to 1,000 rpm, up to 2,000 rpm or up to 3,000 rpm.

14. The method of claim 10, further comprising enclosing the first wafer and the lid dispenser with an inert atmosphere chamber.

## Patentansprüche

1. Wafer-Bearbeitungsvorrichtung zur Oligonukleotidsynthese, die umfasst:
einen Wafer-Transportroboter, der so konfiguriert ist, dass er einen ersten Wafer zur Oligonukleotidsynthese von einer ersten Position zu einer zweiten Position bewegt;
ein Vakuumspannfutter an der zweiten Position, wobei das Vakuumspannfutter den ersten Wafer drehbar hält;
einen Deckelspender an der zweiten Position, wobei der Deckelspender einen transparenten Glasdeckel umfasst und sich der Deckelspender über dem Vakuumspannfutter befindet und entlang einer vertikalen Achse auf den ersten Wafer ausgerichtet ist;
eine vom Deckelspender bereitgestellte Düse, die sich über dem ersten Wafer befindet, wobei die Düse eine Vielzahl von Reagenzien auf eine Oberfläche des ersten Wafers aufträgt; und
eine Reaktionskammer, wobei die Reaktionskammer der Raum zwischen einer Unterseite des Deckelspenders und einer Oberseite des ersten Wafers ist, wobei die Reaktionskammer einen Trennspalt im Bereich von 50 µm bis 2 mm zwischen dem Deckelspender und dem ersten Wafer aufweist, und wobei die Reaktionskammer so konfiguriert ist, dass sie mit der Vielzahl von Reagenzien gefüllt wird, um auf dem ersten Wafer einen Dünnfilm aus der Vielzahl von Reagenzien zu bilden;
wobei das Vakuumspannfutter so konfiguriert ist, dass es den ersten Wafer dreht.

2. Wafer-Bearbeitungsvorrichtung nach Anspruch 1, die ferner eine erste Wafer-Kassette an der ersten Position umfasst, wobei die erste Wafer-Kassette so konfiguriert ist, dass sie mindestens einen zweiten Wafer für die Oligonukleotidsynthese aufnimmt.

3. Wafer-Bearbeitungsvorrichtung nach Anspruch 2, die ferner eine zweite Wafer-Kassette an einer dritten Position umfasst, wobei die zweite Wafer-Kassette so konfiguriert ist, dass sie mindestens einen dritten Wafer für die Oligonukleotidsynthese aufnimmt.

4. Wafer-Bearbeitungsvorrichtung nach Anspruch 3, wobei der Wafer-Transportroboter so konfiguriert ist, dass er den ersten Wafer von der zweiten Position zur dritten Position bewegt.

5. Wafer-Bearbeitungsvorrichtung nach Anspruch 1, die ferner eine Steuereinheit zur Steuerung der Abgabe der Vielzahl an Reagenzien umfasst.

6. Wafer-Bearbeitungsvorrichtung nach Anspruch 1, die ferner eine Inertgas-Kammer umfasst, wobei die Inertgas-Kammer den ersten Wafer und den Deckelspender umschließt, wobei die Inertgas-Kammer einen Lufteinlass und einen Luftauslass umfasst, wobei ein Inertgas durch den Lufteinlass in die Inertgas-Kammer eingeleitet und durch den Luftauslass aus der Inertgas-Kammer abgelassen wird.

7. Wafer-Bearbeitungsvorrichtung nach Anspruch 1, wobei mindestens ein Reliefmuster auf einer Unterseite des Deckelspenders implementiert ist oder mindestens ein Ultraschallmodul innerhalb der Wafer-Bearbeitungsvorrichtung implementiert ist, das zur Verbesserung der Reagenzienabgabe ausgelegt ist.

8. Wafer-Bearbeitungsvorrichtung nach Anspruch 1, die ferner einen Auslass umfasst, wobei der Auslass ein Auslassrohr im Deckelspender ist, das dafür konfiguriert ist, eine Vielzahl von Reagenzien von der Oberfläche des Wafers zu entfernen.

9. Wafer-Bearbeitungsvorrichtung nach Anspruch 1, die ferner eine Vielzahl von Behältern zum Aufnehmen der Vielzahl von Reagenzien enthält, wobei die Düse in Strömungsverbindung mit jedem Behälter steht und diesem funktional zugeordnet ist, um selektiv und nacheinander eine Menge der Vielzahl von Reagenzien abzugeben.

10. Verfahren zur Bearbeitung von Wafern für die Oligonukleotidsynthese unter Verwendung der Wafer-Bearbeitungsvorrichtung nach Anspruch 1, das umfasst:
(a) Bereitstellen des ersten Wafers für die Oligonukleotidsynthese;
(b) Bewegen des ersten Wafers von der ersten Position zur zweiten Position durch den Wafer-Transportroboter;
(c) Platzieren des ersten Wafers auf dem Vakuumspannfutter an der zweiten Position, wobei das Vakuumspannfutter den ersten Wafer drehbar hält;
(d) Abgeben der Vielzahl von Reagenzien in die Reaktionskammer, wobei die Abgabe durch die Düse im Deckelspender erfolgt, während der Wafer stillsteht; und
(e) Verteilen der Vielzahl von Reagenzien über die Oberseite des ersten Wafers, so dass die Reaktionskammer mit der Vielzahl von Reagenzien gefüllt wird, die sich vermischen, um den Dünnfilm zu bilden;
wobei die Düse über dem ersten Wafer angeordnet ist und auf die Mitte des Wafers gerichtet ist, und wobei das Vakuumspannfutter so konfiguriert ist, dass es den ersten Wafer dreht, um die Vielzahl an Reagenzien mit einem zusätzlichen Reagenz über der Oberfläche des ersten Wafers zu vermischen.

11. Verfahren nach Anspruch 10, wobei in Schritt (d) vor dem Aufbringen der Vielzahl an Reagenzien eine vorbestimmte Menge Wasser durch die Düse auf die Oberseite des ersten Wafers aufgebracht wird, der erste Wafer gedreht wird, wobei die Stützsäulen des Deckelspenders so eingestellt werden, dass eine Unterseite des Deckelspenders und die Oberseite des ersten Wafers im Wesentlichen parallel zueinander liegen.

12. Verfahren nach Anspruch 10, wobei das Bewegen des ersten Wafers aus der ersten Position das Entnehmen des ersten Wafers aus einer ersten Wafer-Kassette an der ersten Position umfasst.

13. Verfahren nach Anspruch 10, das ferner umfasst: (f) Entfernen einer Vielzahl von Reagenzien von der Oberfläche des ersten Wafers durch Drehen des ersten Wafers mit bis zu 1.000 U/min, bis zu 2.000 U/min oder bis zu 3.000 U/min.

14. Verfahren nach Anspruch 10, das ferner das Umschließen des ersten Wafers und des Deckelspenders mit einer Inertgas-Kammer umfasst.

## Revendications

1. Appareil de traitement de plaquettes pour la synthèse d'oligonucléotides, comprenant :
un robot de transport de plaquettes configuré pour déplacer une première plaquette pour la synthèse d'oligonucléotides d'une première position vers une deuxième position ;
un mandrin à vide situé à la deuxième position, le mandrin à vide maintenant la première plaquette de manière rotative ;
un distributeur à couvercle situé à la deuxième position, le distributeur à couvercle comprenant un couvercle en verre transparent, et le distributeur à couvercle étant situé au-dessus du mandrin à vide et aligné avec la première plaquette le long d'un axe vertical ;
une buse prévue par le distributeur à couvercle et située au-dessus de la première plaquette, la buse distribuant une pluralité de réactifs sur une surface de la première plaquette ; et
une chambre de réaction, dans lequel la chambre de réaction correspond à l'espace entre une surface inférieure du distributeur à couvercle et une surface supérieure de la première plaquette, dans lequel la chambre de réaction présente un écart de séparation allant de 50 µm à 2 mm entre le distributeur à couvercle et la première plaquette, et dans lequel la chambre de réaction est configurée pour être remplie de la pluralité de réactifs afin de former un film mince de la pluralité de réactifs sur la première plaquette ;
dans lequel le mandrin à vide est configuré pour faire tourner la première plaquette.

2. Appareil de traitement de plaquettes selon la revendication 1, comprenant en outre une première cassette de plaquettes située à la première position, la première cassette de plaquettes étant configurée pour contenir au moins une deuxième plaquette pour la synthèse d'oligonucléotides.

3. Appareil de traitement de plaquettes selon la revendication 2, comprenant en outre une deuxième cassette de plaquettes située à une troisième position, la deuxième cassette de plaquettes étant configurée pour contenir au moins une troisième plaquette pour la synthèse d'oligonucléotides.

4. Appareil de traitement de plaquettes selon la revendication 3, dans lequel le robot de transport de plaquettes est configuré pour déplacer la première plaquette de la deuxième position vers la troisième position.

5. Appareil de traitement de plaquettes selon la revendication 1, comprenant en outre un processeur pour commander la distribution de la pluralité de réactifs.

6. Appareil de traitement de plaquettes selon la revendication 1, comprenant en outre une chambre à atmosphère inerte, la chambre à atmosphère inerte renfermant la première plaquette et le distributeur à couvercle, la chambre à atmosphère inerte comprenant une entrée d'air et une sortie d'air, dans lequel un gaz inerte est introduit dans la chambre à atmosphère inerte par l'entrée d'air et est évacué hors de la chambre à atmosphère inerte par la sortie d'air.

7. Appareil de traitement de plaquettes selon la revendication 1, dans lequel au moins un motif en relief est réalisé sur une surface inférieure du distributeur à couvercle ou au moins un module à ultrasons est intégré à l'intérieur de l'appareil de traitement de plaquettes, configuré pour améliorer le mélange des réactifs.

8. Appareil de traitement de plaquettes selon la revendication 1, comprenant en outre une sortie, dans lequel la sortie est un tube de sortie situé dans le distributeur à couvercle, configuré pour éliminer l'excès de la pluralité de réactifs de la surface de la plaquette.

9. Appareil de traitement de plaquettes selon la revendication 1, comprenant en outre une pluralité de récipients pour contenir la pluralité de réactifs, dans lequel la buse est en communication fluidique et associée de manière opérationnelle à chaque récipient qui distribue de manière sélective et séquentielle une quantité de la pluralité de réactifs.

10. Procédé de traitement de plaquettes pour la synthèse d'oligonucléotides utilisant l'appareil de traitement de plaquettes selon la revendication 1, comprenant :
(a) la fourniture de la première plaquette pour la synthèse d'oligonucléotides ;
(b) le déplacement de la première plaquette de la première position vers la deuxième position par le robot de transport de plaquettes ;
(c) le placement de la première plaquette sur le mandrin à vide situé à la deuxième position, le mandrin à vide maintenant la première plaquette de manière rotative ;
(d) la distribution de la pluralité de réactifs dans la chambre de réaction, dans lequel la distribution est réalisée par la buse située dans le distributeur à couvercle lorsque la plaquette est à l'arrêt ; et
(e) la répartition de la pluralité de réactifs sur la surface supérieure de la première plaquette de sorte que la chambre de réaction soit remplie de la pluralité de réactifs qui se mélangent pour former le film mince ;
dans lequel la buse est placée au-dessus de la première plaquette et dirigée vers le centre de la plaquette, et dans lequel le mandrin à vide est configuré pour faire tourner la première plaquette afin de mélanger la pluralité de réactifs avec un réactif supplémentaire sur la surface de la première plaquette.

11. Procédé selon la revendication 10, dans lequel, à l'étape (d) avant la distribution de la pluralité de réactifs, une quantité prédéterminée d'eau est distribuée sur la surface supérieure de la première plaquette par la buse, la première plaquette est mise en rotation, et les colonnes de support du distributeur à couvercle sont ajustées de sorte que la surface inférieure du distributeur à couvercle et la surface supérieure de la première plaquette soient sensiblement parallèles.

12. Procédé selon la revendication 10, dans lequel le déplacement de la première plaquette de la première position comprend le retrait de la première plaquette d'une première cassette de plaquettes située à la première position.

13. Procédé selon la revendication 10, comprenant en outre (f) l'élimination de l'excès de la pluralité de réactifs de la surface de la première plaquette en faisant tourner la première plaquette à une vitesse allant jusqu'à 1000 tr/min, jusqu'à 2000 tr/min ou jusqu'à 3000 tr/min.

14. Procédé selon la revendication 10, comprenant en outre le confinement de la première plaquette et du distributeur à couvercle dans une chambre à atmosphère inerte.
